# EUROPEAN PATENT SPECIFICATION

(11) **EP 1 229 152 B1**
(45) Date of publication and mention of the grant of the patent: **06.09.2006**
(21) Application number: 02002004.6
(22) Date of filing: 05.02.2002
(51) Int. Cl.: C25D 1/10

(54) **Use of stamper-forming electrode material, use of stamper-forming thin film, and method of manufacturing optical disk**
Verwendung eines matrizenformenden Elektrodenmaterials, Verwendung einer matrizenformenden Dünnschicht und Verfahren zur Herstellung optischer Platten
Utilisation d'un matériau d'électrode pour former une matrice, utilisation d'une couche mince pour former une matrice et procédé de préparation de disques optiques

(30) Priority: 05.02.2001 JP 2001028456; 05.02.2001 JP 2001028457
(43) Date of publication of application: 07.08.2002
(73) Proprietor: Pioneer Corporation, Meguro-ku, Tokyo (JP)
(72) Inventor: Katsumura, Masahiro Pioneer Corporation, Tsurugashima-shi, Saitama-ken (JP); Iida, Tetsuya Pioneer Corporation, Tsurugashima-shi, Saitama-ken (JP); Ueno, Takashi c/o Furuya Metal Co., Ltd., Tokyo-to (JP); Oda, Nobuhiro c/o Furuya Metal Co., Ltd., Tokyo-to (JP)
(74) Representative: Reinhard - Skuhra - Weise & Partner

(56) References cited:
- EP-A- 0 561 080
- US-A- 4 661 212
- US-A- 5 073 237

## Description

The present invention relates to the use of a stamper-forming thin film to form a stamper which is a mold for mass production of optical disks such as compact disks (CDs) and digital versatile disks (DVDs), and to a stamper-forming electrode material for making the stamper-forming thin film. More particularly, the invention is directed to a stamper-forming thin film used as an electrode for forming the stamper by electroforming, and to the use of a stamper-forming electrode material for making the electrode. The invention also relates to a method of manufacturing optical disks such as CDs or DVDs using the stamper.

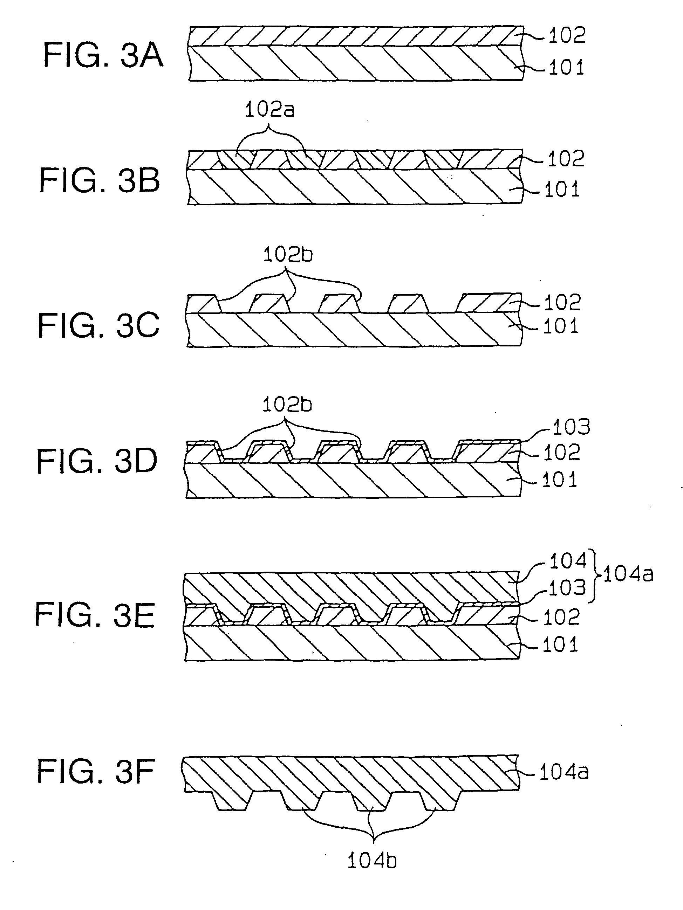

To manufacture optical disks such as CDs or DVDs by a prior art technique, first, as shown in FIG. 3A, a resist film 102 is formed by spin coating or the like on a polished, smooth and flat surface of a supporting plate 101 made of glass. Then, this resist film 102 is patterned. For the patterning, as shown in FIG. 3B, the resist film 102 is exposed to a laser beam to form a latent image 102a, which is thereafter developed. As a result, a pattern 102b of grooves, or otherwise referred to as a grooved pattern 102b, is formed in the surface of the resist film 102, as shown in FIG. 3C.

After the patterning, as shown in FIG. 3D, an electrode film 103 made of a metallic material is deposited on the resist film 102 by sputtering, evaporation, or the like in a manner applying a coating over the entire part of the grooved pattern 102b. The electrode film 103 is made of a single metallic material, nickel (Ni), which is highly conductive and hard to change in composition after film formation, into a uniform thickness. Thereafter, as shown in FIG. 3E, a Ni metallic layer 104 is stacked on the electrode film 103 by electroforming using the film 103 as an electrode.

Then, as shown in FIG. 3F, the metallic layer 104 is separated, together with the electrode film 103, from the surface of the resist film 102 to produce a stamper 104a which is a monolithic member consisting of the electrode film 103 and the metallic layer 104. A surface of the stamper 104a has a pattern 104b of projections, or otherwise referred to as a projected pattern 104b, which has been transferred as the inverse of the grooved pattern 102b. Then, a synthetic resin material is injected into the stamper 104a as a mold toward its projected pattern 104b, to form a substrate on which a grooved pattern exactly identical with the grooved pattern 102b has been copied. Thereafter, a reflector film, a protective layer, etc. are stacked on the substrate in a manner coating the copied grooved pattern, to complete the manufacture of an optical disk.

US 5,073,237 discloses a method of making molds including a step of applying an electrically conductive film, the material of the electrically conductive film being for example a gold, copper, silver and alloys thereof.

US 4,661,212 describes a method for producing a plurality of plate shaped microstructured metal bodies including a step of applying an electrically conductive film. As a material of said film a polymer composition is mentioned.

EP 561 080 A1 relates to a method of manufacturing an optical disk. As one process step a metallic film is introduced, exemplified as silver or nickel.

By the way, latest versions of optical disks are required to have a greater recording density per unit area in order to increase their storage capacity without increasing their size, as in DVDs versus CDs, for example. To meet this requirement, an electron beam is replacing a laser beam during the patterning to implement a narrower groove width, for formation of a higher-definition grooved pattern 102b. For electron-beam exposure, electron-attracting elements such as chlorine, sulphur and fluorine, groups having an electron-attracting function (electron-attracting groups) or the like are added to a resist material for forming the resist film 102b, to provide the resist film 102b with improved electron absorption sensitivity.

However, the use of the resist film 102 with improved electron absorption sensitivity may cause damage, such as deterioration, to the electrode film 103 during electroforming for stacking the metallic layer 104 on the electrode film 103, due to Ni in the electrode film 103 reacting with the electron-attracting elements or groups. Since the surface of the projected pattern 104b of the stamper 104a is formed of the electrode film 103, the damaged electrode film 103 roughens the surface of the projected pattern 104b of the stamper 104a. Thus, such a stamper 104a cannot transfer the grooved pattern 102b to the substrate accurately, resulting in replication of low-performance optical disks with low signal-to-noise ratio (SNR) due to greater noise during data reading.

### SUMMARY OF THE INVENTION

The invention has been made in view of the above problems addressed by the prior art. An object of the invention is, therefore, to use a stamper-forming electrode material and a stamper-forming thin film with improved corrosion resistance to suppress damage to the stamper-forming thin film and hence allow a high-quality stamper to be formed.

Another object of the invention is to provide a method of manufacturing an optical disk with improved SNR and hence with high performance by improving the corrosion resistance of the stamper-forming thin film to suppress damage to the stamper-forming thin film and hence allow a high-quality stamper to be formed.

The above object of the present invention can be achieved by a stamper-forming thin film of the present invention to be coated on a surface of a resist film patterned on a supporting plate. The stamper-forming thin film is provided with a stamper-forming electrode material for forming a stamper by stacking a metallic layer on a surface of said stamper-forming thin film by electroforming using said stamper-forming thin film as an electrode, and thereafter by separating said metallic layer from said resist film, together with said stamper-forming thin film. Further, the material contains silver (Ag) as a main ingredient thereof and at least one other element.

According to the present invention, corrosion resistance is improved, whereby damage to a stamper-forming thin film is suppressed and a high-quality stamper can hence be formed.

Said other element is at least one of gold (Au) and copper (Cu).

In one aspect of the present invention, said material contains Au in an amount of 01-5.0 wt%.

According to this aspect, in addition to the above-mentioned advantages, a better corrosion resistance can be given to a stamper-forming thin film.

In further aspect of the present invention, said material contains Cu in an amount of 0.1-5.0 wt%.

According to this aspect, in addition to the above-mentioned advantages, an even better corrosion resistance can be given to a stamper-forming thin film.

In further aspect of the present invention, said material contains a combination of Au in an amount of 0.1-5.0 wt% and Cu in an amount of 0.1-5.0 wt%.

The above object of the present invention can be achieved by a stamper-forming thin film of the present invention to be coated on a surface of a resist film patterned on a supporting plate. The stamper-forming thin film is provided with a stamper-forming electrode material for forming a stamper by stacking a metallic layer on a surface of said stamper-forming thin film by electroforming using said stamper-forming thin film as an electrode, and thereafter by separating said metallic layer from said resist film, together with said stamper-forming thin film. Further, said material contains silver (Ag) as a main ingredient thereof and at least one other element.

According to the present invention, corrosion resistance is improved, whereby damage to a stamper-forming thin film is suppressed and a high-quality stamper can hence be formed.

Said other element is at least one of gold (Au) and copper (Cu).

In one aspect of the present invention, said material contains Au in an amount of 0.1-5.0 wt%.

According to this aspect, in addition to the above-mentioned advantages, a better corrosion resistance can be given to a stamper-forming thin film.

In further aspect of the present invention, said material contains Cu in an amount of 0.1-5.0 wt%.

According to this aspect, in addition to the above-mentioned advantages, an even better corrosion resistance can be given to a stamper-forming thin film.

In further aspect of the invention, said material contains a combination of Au in an amount of 0.1 - 5.0 wt% and Cu in an amount of 0.1 - 5.0 wt%.

The above object of the present invention can be achieved by a method of manufacturing an optical disk of the present invention. The method is provided with the steps of: forming a resist film on a surface of a supporting plate; forming a predetermined pattern on said resist film by exposure to an electron beam; forming a stamper-forming thin film made of a stamper-forming electrode material on a surface of said patterned resist film; stacking a metallic layer on a surface of said stamper-forming thin film by electroforming using said stamper-forming thin film as an electrode, and thereafter by separating said metallic layer from said resist film, together with said stamper-forming thin film, to form a stamper; injection-molding a substrate made of a synthetic resin using said stamper as a mold; and stacking a reflector film and a protective layer on a surface of said substrate to manufacture said optical disk. Further, said stamper-forming electrode material of which said stamper-forming thin film is made contains Ag as a main ingredient thereof, and has at least one other element added to Ag.

According to the present invention, the corrosion resistance of a stamper-forming thin film is improved to suppress damage to the stamper-forming thin film and hence allow a high-quality stamper to be formed, whereby an optical disk can be manufactured which has improved SNR and hence maintains high performance.

Said other element is at least one of gold (Au) and copper (Cu).

In one aspect of the present invention, said material contains Au in an amount of 0.1-5.0 wt%.

According to this aspect, in addition to the above-mentioned advantages, a better corrosion resistance can be given to a stamper-forming thin film.

In further aspect of the present invention, said material contains Cu in an amount of 0.1-5.0 wt%.

According to this aspect, in addition to the above-mentioned advantages, an even better corrosion resistance can be given to a stamper-forming thin film.

In further aspect of the present invention, said material contains a combination of Au in an amount of 0.1-5.0 wt % and Cu in an amount of 0.1-5.0 wt %.

### BRIEF DESCRIPTION OF THE DRAWINGS

FIG. 1A is a sectional view showing the step of forming a resist film on a supporting plate in a method of manufacturing an optical disk according to an embodiment of the invention;
FIG. 1B is a sectional view showing the step of forming a latent image on the resist film in the method of the invention;
FIG. 1C is a sectional view showing the step of developing the latent image in the method of the invention;
FIG. 1D is a sectional view showing the step of forming an electrode film on the resist film in the method of the invention;
FIG. 1E is a sectional view showing the step of forming a metallic layer on the electrode film by electroforming in the method of the invention;
FIG. 1F is a sectional view showing a stamper of the invention;
FIG. 2A is a sectional view showing the step of forming a substrate using the stamper;
FIG. 2B is a sectional view showing the optical disk;
FIG. 3A is a sectional view showing the step of forming a resist film on a supporting plate in a prior art method of manufacturing an optical disk;
FIG. 3B is a sectional view showing the step of forming a latent image on the resist film in the prior art method;
FIG. 3C is a sectional view showing the step of developing the latent image in the prior art method;
FIG. 3D is a sectional view showing the step of forming an electrode film on the resist film in the prior art method;
FIG. 3E is a sectional view showing the step of forming a metallic layer on the electrode film by electroforming in the prior art method; and
FIG. 3F is a sectional view showing a prior art stamper.

### DETAILED DESCRIPTION OF THE PREFERRED EMBODIMENTS

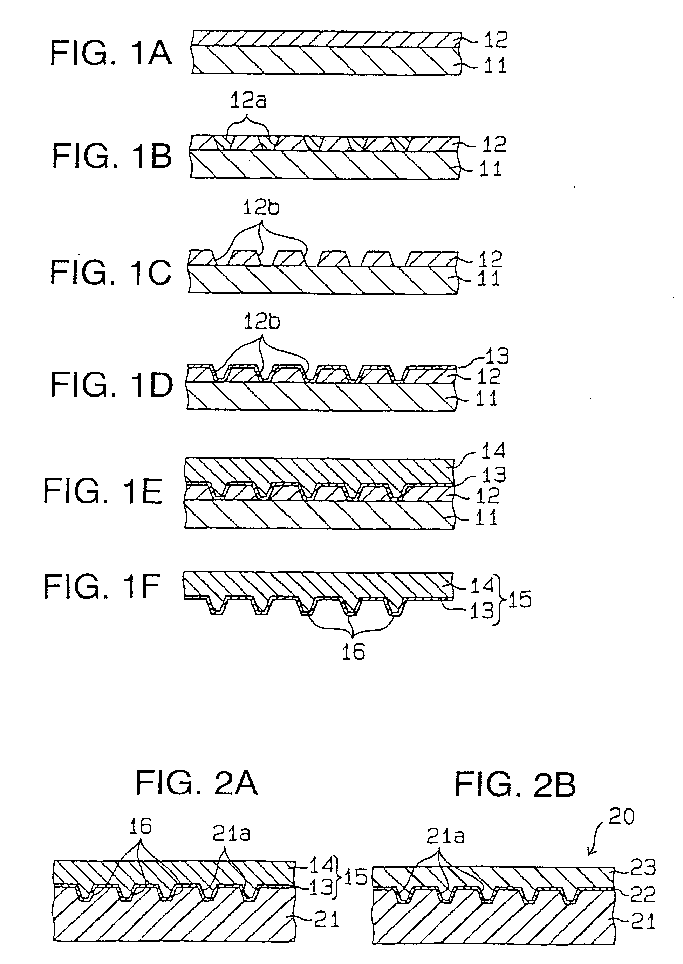

Preferred embodiments of the present invention will be described below with reference to FIGS. 1 and 2.

Referring now to FIG. 2B, a substrate 21, which constitutes an optical disk 20, is a transparent disk-shaped member made of a synthetic resin (polycarbonate), and its upper surface contains a pattern 21a of tiny grooves, or otherwise referred to as a grooved pattern 21a. On the substrate 21, a reflector film 22, which is an aluminum (Al) thin film, is stacked in a manner coating each groove of the pattern 21a. On the reflector film 22, a protective layer 23 made of a UV curable resin is stacked in a manner applying a coating over the entire surface of the substrate 21 while burying each groove of the pattern 21a. The protective layer 23 protects both the grooved pattern 21a and the reflector film 22 against damage.

Referring then to FIG. 2A, the substrate 21 is formed using a metallic stamper 15 molded by a method to be described below. The stamper 15 is formed into a monolithic member by stacking an electrode film 13 on a Ni metallic layer 14. The electrode film 13 is a stamper-forming thin film made of a metallic material (stamper-forming electrode material) and is formed below the metallic layer 14. The lower surface of the stamper 15 has a pattern 16 of projections, or otherwise referred to as a projected pattern 16, which is the inverse of the grooved pattern 21a provided in the substrate 21. To mold the substrate 21, a polycarbonate material is injected into the stamper 15 as a mold toward the projected groove 16 on its lower surface, and the polycarbonate part is then released from the stamper 15 after hardened.

To manufacture the optical disk 20, the reflector film 22 is deposited on the injection-molded substrate 21 by sputtering, evaporation or the like, and then the protective layer 23 is formed on the reflector film 22.

The method of molding the stamper 15 will be described. As shown in FIG. 1A, first, a resist film 12 is formed on a supporting plate 11. A polished, cleaned, smooth and flat surface of the supporting plate 11 made of a glass plate or a silicon wafer is, for example, spin-coated with a liquid resist material to a uniform thickness, and then prebaked for drying the resist material to form the resist film 12 thereon. The resist material contains electron-attracting elements such as chlorine, sulphur and fluorine, or electron-attracting groups, and thus the deposited resist film 12 has improved electron absorption sensitivity.

Then, the resist film 12 is patterned. As shown in FIG. 1B, the resist film 12 is exposed to an electron beam from top to form a latent image 12a on its surface, whereby data signals are recorded. Then, as shown in FIG. 1C, the resist film 12 is developed to remove the latent image 12a portion, whereby a pattern 12b of grooves, or a grooved pattern 12b, is provided therein. Successively, the resultant resist film 12 is postbaked to complete its patterning step.

Then, as shown in FIG. 1D, the electrode film 13 made of the stamper-forming electrode material (metallic material) as the stamper-forming thin film is deposited on the upper surface of the resist film 12 to a uniform thickness by a process such as sputtering, evaporation, or electroless plating. At this stage, the shape of the grooved pattern 12b has been accurately transferred to the electrode film 13.

Lastly, the stamper 15 is formed. As shown in FIG. 1E, electroforming is performed using the electrode film 13 as an electrode to deposit Ni on the electrode film 13 as the metallic layer 14. Thereafter, this metallic layer 14 is separated, together with the electrode film 13, from the surface of the resist film 12 and supporting plate 11, to obtain the stamper 15 in the form of a monolithic member consisting of the metallic layer 14 and the electrode film 13, as shown in FIG. 1F.

The lower surface of the stamper 15 is provided, through the electrode film 13, with the projected pattern 16 which is the exact opposite of the grooved pattern 12b accurately transferred to the electrode film 13. This stamper 15 is thus used to injection-mold the substrate 21 that constitutes the optical disk 20, as mentioned above.
Once formed, the stamper 15 may subsequently be used as a master stamper to prepare a submaster stamper having the grooved pattern, by electroforming its surface provided with the projected pattern 16. Thereafter, a plurality of baby stampers each being identical in shape with the master stamper are prepared using the submaster stamper, to replicate the substrates 21 of optical disks 20 by injection molding.

The stamper-forming electrode material (metallic material) for making the electrode film 13 contains silver (Ag) as its main ingredient, and at least one other element. Silver is contained because it is highly conductive and less susceptible to chemical reaction with the electron-attracting elements or groups present in the resist material. The term "main ingredient" herein means an ingredient contained most in the stamper-forming electrode material. The at least one other element is selected preferably from gold (Au) and copper (Cu) which can easily improve the corrosion resistance of the electrode film 13 as the stamper-forming thin film.

The stamper-forming electrode material according to this embodiment contains Ag as its main ingredient, and Au and Cu selected from the above-listed metallic elements as additives. The addition of Au and Cu to the stamper-forming electrode material contributes to improving the corrosion resistance of the electrode film 13 to electron-attracting elements such as chlorine, sulphur and fluorine, or substances containing such elements as electron-attracting groups, while maintaining the conductivity of the film 13.

The element Au is added to the stamper-forming electrode material preferably in an amount of 5.0 percent by weight (wt%) or less, more preferably 3.0 wt% or less, or even more preferably 1.5 wt% or less, but still ≥ 0.1 wt%. The Au content greater than 5.0 wt% may make Au hard to form colloidal mixtures with Ag and Cu depending on how they are contained to compose the material, or may produce a metallic material with unstable properties or with an undesired corrosion resistance. Moreover, the Cu content in the stamper-forming electrode material is set preferably to 5.0 wt% or less, more preferably to 3.0 wt% or less, or even more preferably to 1.5 wt% or less, but still ≥ 0.1 wt%. The Cu content greater than 5.0 wt% may make Cu hard to form colloidal mixtures with Ag and Au depending on how they are contained to compose the material, or may produce a metallic material with unstable properties or with an undesired corrosion resistance.

Advantages provided by the above embodiment are as follows. The electrode film 13 as the stamper-forming thin film according to the embodiment is made of the stamper-forming electrode material (metallic material) containing Ag, Au, and Cu. This material containing Ag, Au, and Cu, due to its high corrosion resistance to electron-attracting elements such as chlorine, sulphur and fluorine, or substances having such elements as electron-attracting groups, prevents damage, such as deterioration, to the electrode film 13 during formation of the Ni metallic layer 14 by electroforming.

Since the surface of the projected pattern 16 on the stamper is formed of this electrode film 13, the same surface can be maintained as smooth and planar as it is when the grooved pattern 12b of the resist film 12 has been transferred accurately to the electrode film 13. Thus, the substrate 21 of the optical disk 20 prepared by such a stamper 15 is provided with the grooved pattern 21a exactly identical with the grooved pattern 12b of the resist film 12, as well as smooth and planar inside surfaces in the grooves of the pattern 21a. These smooth and planar surfaces suppress irregular reflection of laser light emitted from an optical pickup for reading data recorded on the optical disk 20, to improve the signal-to-noise ratio (SNR), whereby the optical disk 20 can maintain high performance.

Both the Au and Cu contents in the stamper-forming electrode material are set to 0.1-5.0 wt% whereby the corrosion resistance of the electrode film 13 can be further improved synergistically.

### [EXAMPLES]

The above embodiment will be described more specifically with reference to illustrative non-limiting examples and comparative examples which follow.

### (Examples 1-5; Comparative Example 1)

Electrode films 13 containing Ag, Au, and Cu, were formed on quartz substrates using an RF sputtering system. Specifically, three kinds of sputtering targets, Au, Ag, and Cu, were disposed in the RF sputtering system for simultaneous deposition on the respective substrates by sputtering to form the electrode films 13 on the substrates. Each sputtering target was 7.62 cm (3 inches) in diameter and 5 mm in thickness, and its distance to the substrate was about 90 cm. The films were formed under a vacuum of 3×10⁻⁵ Pa, a gas pressure of 0.7-1.0 Pa, and an RF power of 100-500W.

In each example, the Au content was varied while the Cu content was fixed at 0.1 wt% to form the electrode film 13. The contents of these elements were adjusted by controlling ejection of their metallic atoms, while the ejection control was performed by adjusting RF power to be applied to the respective sputtering targets.

### (Comparative Example 2)

An electrode film 13 consisting only of Ag was formed on a quartz substrate using the RF sputtering system. An Ag sputtering target, which was 7.62 (3 inches) in diameter and 5 mm in thickness, was disposed in the RF sputtering system to be sputtered at a distance of about 90 cm to the substrate. The film was formed under a vacuum of 3×10⁻⁵ Pa, a gas pressure of 0.7-1.0 Pa, and an RF power of 100-500W.

### (Evaluation of Corrosion Resistance)

The electrode films 13 obtained as Examples 1 to 5 and Comparative Examples 1 and 2 were immersed in an aqueous sodium chloride (NaCl) solution whose concentration was 5 percent by volume (vol%), together with the quarts substrates at room temperature for predetermined times, for evaluation to see if they changed with time. Table 1 shows the results. The chemical composition of each metallic material, i.e., the contents of its constituent metallic elements are indicated on a wt% basis. The changes with time were visibly evaluated by those responsible for measurement. In the following tables, "G" denotes no deterioration on the electrode film 13 surface, "OK" denotes slight deterioration on the electrode film 13 surface, and "NG" denotes deterioration on the electrode film 13 surface, during measurement. The aqueous NaCl solution was used to verify the assumption that chlorine and sodium to be contained in an arbitrarily selected resist material would corrode the electrode film 13.

**[Table 1]**

| | Composition (wt%) | | | Result from immersion in aqueous NaCl solution |
|---|---|---|---|---|
| Sample No. | Ag | Au | Cu | |
| Example 1 | 99.8 | 0.1 | 0.1 | G |
| Example 2 | 99.2 | 0.7 | 0.1 | G |
| Example 3 | 98.4 | 1.5 | 0.1 | G |
| Example 4 | 96.9 | 3.0 | 0.1 | G |
| Example 5 | 94.9 | 5.0 | 0.1 | G |
| Comparative Example 1 | 93.9 | 6.0 | 0.1 | NG |
| Comparative | | | | |
| Example 2 | 100 | 0 | 0 | NG |

As is apparent from the results of Table 1, Comparative Example 2 deteriorated to have the entire end of its electrode film 13 surface turned yellow when immersed in the aqueous NaCl solution. This demonstrates that any of metallic elements in the metallic material reacted with chlorine. In comparative Example 1, its electrode film 13 deteriorated to have part of the end of the surface slightly turned yellow. In contrast to these examples, Examples 1 to 5 exhibited no deterioration on the surfaces of their electrode films 13 from immersion in the aqueous NaCl solution. Thus, it is taught that addition of Au and Cu to the metallic material contributes to improving corrosion resistance.

When the Au content was varied within the range 0.1-6.0 wt% with the Cu content fixed, the surface of the electrode film 13 did not deteriorate in each of Examples 1 to 5, but slightly deteriorated in Comparative Example 1. This teaches that the Au content should be set preferably to 5.0 wt% or less, and further that the Au content should be set preferably to 1 to 50 times the Cu content when the Ag content is 94-99.9 wt%. Based on these teachings, an optimum Cu content for preparing an electrode film 13 was sought in the following examples.

### (Examples 7-10; Comparative Example 3)

In Examples 7 to 10 and Comparative Example 3 electrode films 13 were formed by sputtering Ag, Au, and Cu, while controlling ejection of their metallic atoms similarly to Examples 1 to 5 and Comparative Example 1 provided that the Cu content was varied with the Au content fixed at 5.0 wt%. The obtained electrode films 13 were similarly evaluated for their corrosion resistance. Table 2 shows the results.

**[Table 2]**

| | Composition (wt%) | | | Result from immersion in aqueous NaCl solution |
|---|---|---|---|---|
| Sample No. | Ag | Au | Cu | |
| Example 7 | 94.3 | 5.0 | 0.7 | G |
| Example 8 | 93.5 | 5.0 | 1.5 | G |
| Example 9 | 92 | 5.0 | 3.0 | G |
| Example 10 | 90 | 5.0 | 5.0 | G |
| Comparative Example 3 | 89 | 5.0 | 6.0 | NG |

As is apparent from Table 2, in Examples 7 to 10, the surfaces of their electrode films 13 did not deteriorate from immersion in the aqueous NaCl solution. In Comparative Example 3, the surface of its electrode film 13 deteriorated to have part of the end of the surface slightly turned yellow. That is, the surface of the electrode film 13 did not deteriorate in each of Examples 7 to 10, but slightly deteriorated in Comparative Example 3 when the Cu content was varied over the range 0.7-6.0 wt% with the Au content unvaried. This teaches that the Cu content should be set preferably to 5.0 wt% or less, and further that the Au content should be set preferably to 1.0 to 7.5 times the Cu content when the Ag content is 90-95.0 wt%,

Based on the above teachings, further optimum conditions for preparing an electrode film 13 were sought in the following examples.

### (Examples 12-18)

In Examples 12 to 18, electrode films 13 were formed by sputtering Ag, Au, and Cu, while controlling ejection of their metallic atoms similarly to Examples 1 to 5 and Comparative Example 1, provided that the Cu content was varied with the Au content fixed at 0.5 wt% for Examples 12 to 16 and that the Au content was varied with the Cu content fixed at 0.5 wt% for Examples 17 and 18. The obtained electrode films 13 were similarly evaluated for their corrosion resistance while immersed in a 5 vol.% aqueous NaCl solution at room temperature for 5, 10, and 24 hours. Table 3 shows the results.

**[Table 3]**

| | Composition (wt%) | | | Immersion time(hours) | | |
|---|---|---|---|---|---|---|
| Sample No. | Ag | Au | Cu | 5 | 10 | 24 |
| Example 12 | 94.5 | 0.5 | 5.0 | G | NG | - |
| Example 13 | 96.0 | 0.5 | 3.5 | G | G | NG |
| Example 14 | 97.5 | 0.5 | 2.0 | G | G | NG |
| Example 15 | 98.0 | 0.5 | 1.5 | G | G | G |
| Example 16 | 98.5 | 0.5 | 1.0 | G | G | G |
| Example 17 | 94.5 | 5.0 | 0.5 | G | G | G |
| Example 18 | 96.5 | 3.0 | 0.5 | G | G | G |

As is apparent from Table 3, in Example 12, the surface of its electrode film 13 did not deteriorate when immersed for 5 hours, but deteriorated when immersed for 10 hours. In Examples 13 and 14, the surfaces of their electrode films 13 did not deteriorate when immersed for 5 to 10 hours, but deteriorated when immersed for 24 hours. In Examples 15 to 18, the surfaces of their films 13 did not deteriorate even from a 24-hour immersion.

A comparison between Examples 12 and 13 shows that Example 13 had a higher corrosion resistance than Example 12 despite the fact that both contained 0.5 wt% Au. This suggests that the Cu content be set more preferably to 3.5 wt% or less when the Au content is 0.5 wt%. Another comparison between Examples 14 and 15 shows that Example 15 had a higher corrosion resistance than Example 14 despite the fact that both contained 0.5 wt% Au. This further suggests that the Cu content be set even more preferably to 1.5 wt% or less when the Au content is 0.5 wt%. It is also taught that the Cu content should be 1 to 3 times the Au content when the Ag content is 98-99 wt%,

In contrast to these examples, both Examples 17 and 18 wherein the Cu content was fixed at 0.5 wt% exhibited an extremely high corrosion resistance. This suggests that the best corrosion resistance be given when the Cu content is set to 0.5 wt% or less and the Au content to 5.0 wt% or less. It is further taught that the Au content should be set preferably to 6 to 10 times the Cu content when the Ag content is 94-97 wt%.

As alternatives, this embodiment may be modified as follows. As to the substrate 21, the reflector film 22, and the protective layer 23, although the optical disk 20 according to this embodiment includes only one layer each, an optical disk 20 may also include two or more layers each.

Additionally, the following are some technical ideas which could be taught by the above embodiments.
(1) A stamper-forming electrode material according to claim 1, wherein the material contains Ag in an amount of 94-99.9 wt%, and Au and Cu such that the ratio in terms of content of Au to Cu is set to 1.0-50.0 on a weight basis. According to this arrangement, a better corrosion resistance can be given to a stamper-forming thin film for forming a stamper.
(2) A stamper-forming electrode material according to claim 1, wherein the material contains Ag in an amount of 98-99 wt%, and Au and Cu such that the ratio in terms of content of Au to Cu is set to 1.0-3.0 on a weight basis. According to this arrangement, an even better corrosion resistance can be given to a stamper-forming thin film for forming a stamper.
(3) A stamper-forming electrode material according to claim 1, wherein the material contains Ag in an amount of 94-97 wt%, and Au and Cu such that the ratio in terms of content of Au to Cu is set to 6.0-10.0 on a weight basis. According to this arrangement, an even better corrosion resistance can be given to a stamper-forming thin film for forming a stamper.
(4) A stamper-forming thin film comprising the stamper-forming electrode material mentioned in any of (1) to (3) above. According to this arrangement, a further better corrosion resistance can be given to the stamper-forming thin film for forming a stamper.
(5) A method of manufacturing an optical disk of the present invention, wherein the stamper-forming electrode material contains Ag as a main ingredient thereof, and at least one other element selected from Au and Cu. According to this arrangement, a good corrosion resistance can be given to a stamper-forming thin film for forming a stamper.
(6) A method of manufacturing an optical disk of the present invention, wherein the stamper-forming electrode material contains Ag in an amount of 94-99.9 wt%, and Au and Cu such that the ratio in terms of content of Au to Cu is set to 1.0-50.0 on a weight basis. According to this arrangement, a better corrosion resistance can be given to a stamper-forming thin film for forming a stamper.
(7) A method of manufacturing an optical disk of the present invention, wherein the stamper-forming electrode material contains Ag in an amount of 98-99 wt%, and Au and Cu such that the ratio in terms of content of Au to Cu is set to 1.0-3.0 on a weight basis. According to this arrangement, an even better corrosion resistance can be given to a stamper-forming thin film for forming a stamper.
(8) A method of manufacturing an optical disk of the present invention, wherein the stamper-forming electrode material contains Ag in an amount of 94-97 wt%, and Au and Cu such that the ratio in terms of content of Au to Cu is set to 6.0-10.0 on a weight basis. According to this arrangement, an even better corrosion resistance can be given to a stamper-forming thin film for forming a stamper.

## Claims

1. Use of a stamper-forming electrode material for making a stamper-forming thin film (13) to be coated on a surface of a resist film (12) patterned on a supporting plate (11), for forming a stamper (15) by stacking a metallic layer (14) on a surface of said stamper-forming thin film by electroforming, wherein said stamper-forming thin film is used as an electrode, and thereafter said metallic layer is separated from said resist film, together with said stamper-forming thin film,
the stamper-forming electrode material being **characterized in that** said material contains silver (Ag) as a main ingredient thereof and at least one other element selected from the group consisting of gold (Au) in an amount of 0.1-5.0 wt.-%; copper (Cu) in an amount of 0.1-5.0 wt.-%; and a combination of Au in an amount of 0.1-5.0 wt.-% and Cu in an amount of 0.1-5.0 wt.-%.

2. Use of a stamper-forming thin film (13) to be coated on a surface of a resist film (12) patterned on a supporting plate (11), comprising a stamper-forming electrode material for forming a stamper (15) by stacking a metallic layer (14) on a surface of said stamper-forming thin film by electroforming as an electrode, whereafter said metallic layer is separated from said resist film, together with said stamper-forming thin film, the stamper-forming electrode material being **characterized in that** said material contains silver (Ag) as a main ingredient thereof and at least one other element selected from the group consisting of gold (Au) in an amount of 0.1-5.0 wt.-%; copper (Cu) in an amount of 0.1-5.0 wt.-%; and a combination of Au in an amount of 0.1-5.0 wt.-% and Cu in an amount of 0.1-5.0 wt.-%.

3. A method of manufacturing an optical disk comprising the steps of:
forming a resist film (12) on a surface of a supporting plate (11);
forming a predetermined pattern on said resist film by exposure to an electron beam;
forming a stamper-forming thin film (13) made of a stamper-forming electrode material on a surface of said patterned resist film;
stacking a metallic layer (14) on a surface of said stamper-forming thin film by electroforming using said stamper-forming thin film as an electrode, and thereafter by separating said metallic layer from said resist film, together with said stamper-forming thin film, to form a stamper (15);
injection-molding a substrate (21) made of a synthetic resin using said stamper as a mold; and
stacking a reflector film (22) and a protective layer on a surface of said substrate to manufacture said optical disk,
wherein said stamper-forming electrode material of which said stamper-forming thin film is made contains Ag as a main ingredient thereof, and has at least one other element added to Ag, the other element being selected from the group consisting of gold (Au) in an amount of 0.1-5.0 wt.-%; copper (Cu) in an amount of 0.1-5.0 wt.-%; and a combination of Au in an amount of 0.1-5.0 wt.-% and Cu in an amount of 0.1-5.0 wt.-%.

## Patentansprüche

1. Verwendung eines matrizenbildenden Elektrodenmaterials zum Herstellen eines matrizenbildenden Dünnfilms (13), der auf eine Oberfläche eines Resistfilms (12), der auf einer Trägerplatte (11) strukturiert wurde, aufgetragen wird, zum Ausbilden einer Matrize (15) durch Aufschichten einer metallischen Schicht (14) auf einer Oberfläche des matrizenbildenden Dünnfilms durch Galvanoplastik, wobei der matrizenbildende Dünnfilm als eine Elektrode verwendet wird, und danach die metallische Schicht zusammen mit dem matrizenbildenden Dünnfilm von dem Resistfilm getrennt wird,
wobei das matrizenbildende Elektrodenmaterial **dadurch gekennzeichnet ist, dass** das Material Silber (Ag) als einen Hauptbestandteil davon enthält, und mindestens ein anderes Element, ausgewählt aus der Gruppe, bestehend aus Gold (Au) in einer Menge von 0,1-5,0 Gew.-%; Kupfer (Cu) in einer Menge von 0,1-5,0 Gew-%; und einer Kombination von Au in einer Menge von 0,1-5,0 Gew.-% und Cu in einer Menge von 0,1-5,0 Gew.-%.

2. Verwendung eines matrizenbildenden Dünnfilms (13), der auf eine Oberfläche eines Resistfilms (12), der auf einer Trägerplatte (11) strukturiert wurde, aufgetragen wird, umfassend ein matrizenbildendes Elektrodenmaterial zum Ausbilden einer Matrize (15) durch Aufschichten einer metallischen Schicht (14) auf einer Oberfläche des matrizenbildenden Dünnfilms durch Galvanoplastik als eine Elektrode, wonach die metallische Schicht zusammen mit dem matrizenbildenden Dünnfilm von dem Resistfilm getrennt wird, wobei das matrizenbildende Elektrodenmaterial **dadurch gekennzeichnet ist, dass** das Material Silber (Ag) als einen Hautbestandteil davon enthält, und mindestens ein anderes Element, ausgewählt aus der Gruppe, bestehend aus Gold (Au) in einer Menge von 0,1-5,0 Gew.-%; Kupfer (Cu) in einer Menge von 0,1-5,0 Gew.-%; und einer Kombination von Au in einer Menge von 0,1-5,0 Gew.-% und Cu in einer Menge von 0,1-5,0 Gew.-%.

3. Verfahren zur Herstellung einer optischen Platte mit den Schritten:
Ausbilden eines Resistfilms (12) auf einer Oberfläche einer Trägerplatte (11);
Ausbilden eines vorherbestimmten Musters auf dem Resistfilm durch Belichten mit einem Elektronenstrahl;
Ausbilden eines matrizenbildenden Dünnfilms (13), hergestellt aus einem matrizenbildenden Elektrodenmaterial, auf einer Oberfläche des strukturierten Resistfilms;
Aufschichten einer metallischen Schicht (14) auf einer Oberfläche des matrizenbildenden Dünnfilms durch Galvanoplastik unter Verwendung des matrizenbildenden Dünnfilms als eine Elektrode, und danach durch Trennen der metallischen Schicht zusammen mit dem matrizenbildenden Dünnfilm von dem Resistfilm, um eine Matrize (15) zu bilden;
Spritzgießen eines Substrates (21), hergestellt aus einem synthetischen Harz, unter Verwendung der Matrize als Pressform; und
Aufschichten eines Reflektorfilms (22) und einer Schutzschicht auf einer Oberfläche des Substrates, um die optische Platte herzustellen,
wobei das matrizenbildende Elektrodenmaterial, aus dem der matrizenbildende Dünnfilm hergestellt ist, Silber als einen Hauptbestandteil davon enthält, und mindestens ein anderes Element, das zu dem Silber dazugegeben wird, enthält, wobei das andere Element ausgewählt ist aus der Gruppe, bestehend aus Gold (Au) in einer Menge von 0,1-5,0 Gew.-%; Kupfer (Cu) in einer Menge von 0,1-5,0 Gew.-%; und einer Kombination von Au in einer Menge von 0,1-5,0 Gew.-% und Cu in einer Menge von 0,1-5,0 Gew.-%.

## Revendications

1. Utilisation d'un matériau d'électrode formant matrice, pour constituer une couche mince formant matrice (13), à revêtir sur une surface d'une pellicule de protection (12) avec motif sur une plaque d'assise (11), pour former une matrice (15) en superposant une couche métallique (14) à une surface de ladite couche mince formant matrice, par électroformage, dans laquelle ladite couche mince formant matrice est utilisée comme électrode et, par la suite, ladite couche métallique est détachée de ladite pellicule de protection, en même temps que ladite couche mince formant matrice,
le matériau d'électrode formant matrice étant **caractérisé en ce que** ledit matériau contient de l'argent (Ag) comme composant principal, et au moins un autre élément choisi dans le groupe constitué d'or (Au) dans une quantité comprise entre 0,1 et 5,0 % en poids ; de cuivre (Cu) dans une quantité comprise entre 0,1 et 5,0 % en poids ; et une combinaison de Au dans une quantité comprise entre 0,1 et 5,0 % en poids et de Cu dans une quantité comprise entre 0,1 et 5,0 % en poids.

2. Utilisation d'une couche mince formant matrice (13) à revêtir sur une surface d'une pellicule de protection (12) avec motif sur une plaque d'assise (11), comprenant un matériau d'électrode formant matrice pour former une matrice (15) en superposant une couche métallique (14) à une surface de ladite couche mince formant matrice par électroformage comme électrode, dans laquelle ladite couche métallique est ensuite détachée de ladite pellicule de protection, en même temps que ladite couche mince formant matrice, le matériau d'électrode formant matrice étant **caractérisé en ce que** ledit matériau contient de l'argent (Ag) comme composant principal et au moins un autre élément choisi dans le groupe constitué d'or (Au) dans une quantité comprise entre 0,1 et 5,0 % en poids ; de cuivre (Cu) dans une quantité comprise entre 0,1 et 5,0 % en poids ; et une combinaison de Au dans une quantité comprise entre 0,1 et 5,0 % en poids et de Cu dans une quantité comprise entre 0,1 et 5,0 % en poids.

3. Procédé de fabrication d'un disque optique, comprenant les étapes consistant à :
former une pellicule de protection (12) sur une surface d'une plaque d'assise (11) ;
former un motif prédéfini sur ladite pellicule de protection par exposition à un faisceau électronique ;
former une couche mince formant matrice (13) constituée d'un matériau d'électrode formant matrice, sur une surface de ladite pellicule de protection avec motif;
superposer une couche métallique (14) à une surface de ladite couche mince formant matrice, par électroformage en utilisant ladite couche mince formant matrice comme électrode et, par la suite, en détachant ladite couche métallique de ladite pellicule de protection, en même temps que ladite couche mince formant matrice, pour former une matrice (15) ;
mouler par injection un support (21) constitué d'une résine synthétique, en utilisant comme moule ladite matrice ; et
superposer une pellicule réfléchissante (22) et une couche protectrice à une surface dudit support, pour préparer ledit disque optique,
dans lequel ledit matériau d'électrode formant matrice, qui constitue ladite couche mince formant matrice, contient du Ag comme composant principal, et a au moins un autre élément ajouté au Ag, l'autre élément étant choisi dans le groupe constitué d'or (Au) dans une quantité comprise entre 0,1 et 5,0 % en poids ; de cuivre (Cu) dans une quantité comprise entre 0,1 et 5,0 % en poids ; et une combinaison de Au dans une quantité comprise entre 0,1 et 5,0 % en poids, et de Cu dans une quantité comprise entre 0,1 et 5,0 % en poids.
